# EUROPÄISCHE PATENTSCHRIFT

(11) **EP 1 651 022 B1**
(45) Veröffentlichungstag und Bekanntmachung des Hinweises auf die Patenterteilung: **19.05.2010**
(21) Anmeldenummer: 05021992.2
(22) Anmeldetag: 08.10.2005
(51) Int. Cl.: H05K 7/14, H05B 3/74

(54) **Halter für einen Bauteilträger**
support for a component
Support pour un composant

(30) Priorität: 20.10.2004 DE 102004052202
(43) Veröffentlichungstag der Anmeldung: 26.04.2006
(73) Patentinhaber: E.G.O. ELEKTRO-GERÄTEBAU GmbH, 75038 Oberderdingen (DE)
(72) Erfinder: Winkler, Uwe, 76275 Ettlingen (DE)
(74) Vertreter: Patentanwälte Ruff, Wilhelm, Beier, Dauster & Partner

(56) Entgegenhaltungen:
- EP-A2- 1 139 695
- DE-A1- 4 419 866
- GB-A- 2 151 833
- US-A- 5 137 248

## Beschreibung

### Anwendungsgebiet und Stand der Technik

Die Erfindung betrifft einen Halter für die Fixierung von wenigstens einem flächigen Bauteilträger gemäß dem Oberbegriff des Anspruch 1.

Eine derartige Anordnung ist beispielsweise aus der DE 44 19 866 A1 bekannt. Darin wird eine Steuerungsanordnung für ein Elektrowärmegerät beschrieben, dessen Steuereinheit in einem an die Unterseite einer Glaskeramikplatte angelegten Gehäuse unterzubringen ist. Teil dieser Steuereinheit ist eine Sensorleiterplatte, die mit Federelementen gegen die Glaskeramikplatte gedrückt wird. Dies ist notwendig, da die Sensorleiterplatte verschiedenartige Berührschalter aufweisen kann. Die Federelemente dienen weiterhin als elektrische Verbindung zwischen der Sensorleiterplatte und weiteren Bauteilträgern. Dazu können sie in SMD-Technik ausgebildet sein und beim Verlöten dauerhaft mit der Sensorleiterplatte und/oder dem anderen Bauteilträger kontaktiert werden. Nachteilig zeigt sich hierbei, dass die Anordnung äußerst unflexibel ist. Im Falle eines Defektes muss sehr aufwendig und zeitintensiv eine komplette Baugruppe entweder ausgetauscht oder auseinandergebaut und repariert werden. Ebenfalls nachteilig ist der erhöhte Aufwand bei der Montage. Im übrigen sind die Angriffspunkte der Kräfte, die durch die Federn erzeugt werden, ungleichmäßig über die Sensorleiterplatte verteilt und es muss für jeden Typ Sensorleiterplatte eine eigene Federanordnung gefunden werden.

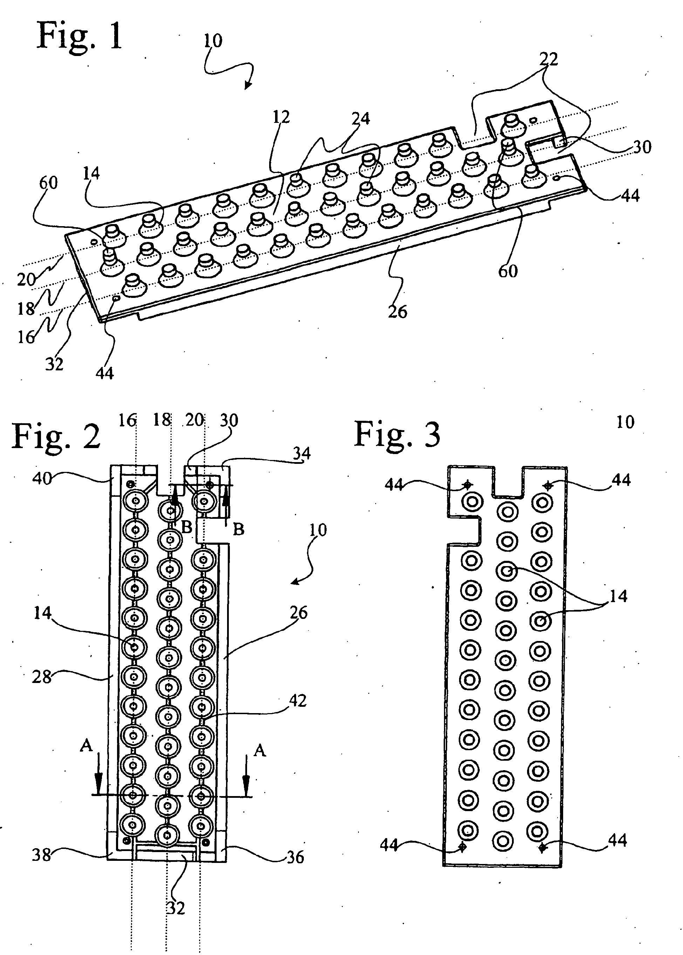

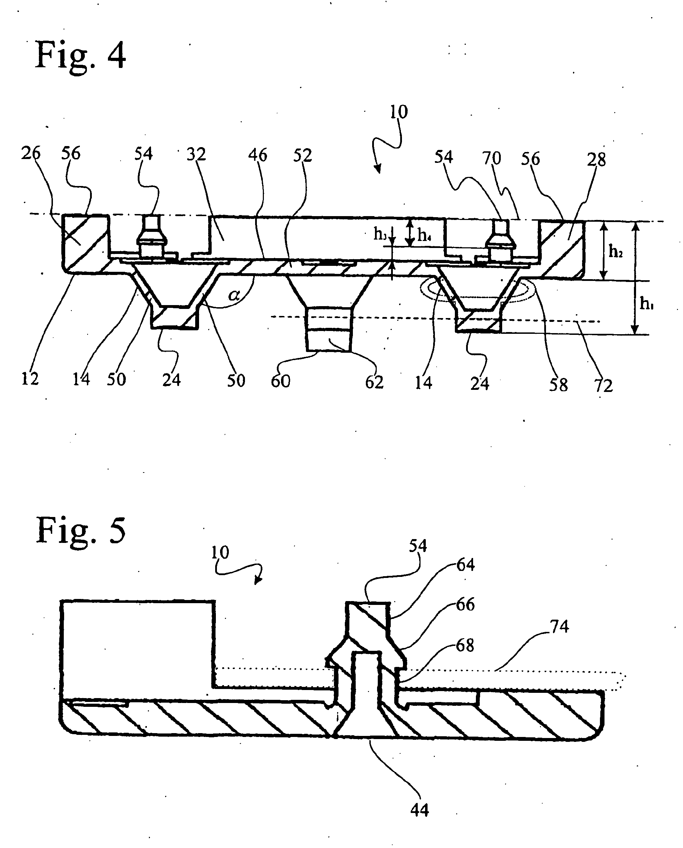

Die US 5,137,248 beschreibt eine Anordnung, um elastische Bauteile an Gehäuseteile zu montieren. Dazu kann gemäß Figur 1a ein x-förmiger Aufbau geschaffen werden mit Füssen, die gleichzeitig Standbeine für das Gehäuse bilden. Dieser Aufbau kann gemäß Figur 5 mit Trägern eine Leiterplatte tragen, wobei die Leiterplatte mittels Haltern festgehalten wird.

### Aufgabe und Lösung

Aufgabe der Erfindung ist es, einen Halter der eingangs genannten Art zu schaffen, der zum einen universell für verschiedene Bauteilträger anwendbar ist, und zum anderen eine Anpresskraft bereitstellt, die sich über den Halter möglichst gleichmäßig verteilt.

Gelöst wird diese Aufgabe durch einen Halter mit den Merkmalen des Anspruchs 1. Vorteilhafte sowie bevorzugte Ausgestaltungen der Erfindung sind Gegenstand der weiteren Ansprüche und werden im Folgenden näher erläutert. Der Wortlaut der Ansprüche wird durch ausdrückliche Bezugnahme zum Inhalt der Beschreibung gemacht.

Erfindungsgemäß weist der Halter eine Anzahl von elastischen Vorsprüngen auf, die an einer Seite des Halters einstückig und flächig verteilt sind und eine Flächenfeder bilden. Die Anzahl der Vorsprünge kann variieren. Sie liegt in einem Bereich zwischen 1 und 500, vorzugsweise zwischen 3 und 40. Der Halter weist vorzugsweise eine flächige, leicht dicke oder sogar zumindest teilweise quaderförmige Ausbildung auf, ist dabei jedoch deutlich breiter und länger als hoch, also im wesentlichen flach. Die Seite des Halters, an der die Vorsprünge verteilt sind, kann eine der schmalen, umlaufenden Seiten des Halters sein, ebenso jedoch auch eine der beiden Grundseiten. Die Vorsprünge, die an einer der umlaufenden Seiten des Halters angebracht sind, können dabei wulst- oder rohrartig sein. Die an der flächigen Seite des Halters vorgesehenen Vorsprünge können eine spitze, runde, flache oder sonstige vorstellbare Geometrie aufweisen. Das Material, aus dem der Halter gefertigt wird, weist vorteilhaft zumindest teilweise federelastische Eigenschaften auf.

Gemäß der Erfindung sind die Vorsprünge Hohlkörper. Der Bereich des Hohlkörpers, der nicht an einem Untergrund anliegt, der eine Kontaktfläche mit dem Halter bildet, stellt dabei hauptsächlich das federnde Element dar Dieses lässt sich in seinen mechanischen Eigenschaften sehr einfach berechnen und kann so gezielt auf definierte Anforderungen ausgelegt werden.

In einer weiteren Ausgestaltung der Erfindung weisen die Vorsprünge zueinander einen geringen Abstand auf, wobei der Abstand vorzugsweise in etwa der Breite eines Vorsprungs entspricht. Durch die geringen Abstände kann die Federkraft sehr gleichmäßig verteilt werden. Vorzugsweise sind die Abstände zwischen den verschiedenen Vorsprüngen weitestgehend identisch.

In einer weiteren Ausgestaltung der Erfindung weisen die Vorsprünge eine Becherform auf, die insbesondere kegelstumpfartig ist, wobei diese vorzugsweise einen länglichen oder weitestgehend zylindrischen Zapfen an deren kleineren Durchmesserseite aufweisen. Mit deren freier Stirnseite sind die Körper an einem flächigen Untergrundelement des Unterbaus anlegbar, wobei sie vorzugsweise mit der größeren Durchmesserseite in den flächigen Halter übergehen. Durch die kegelstumpfartige Ausformung der Vorsprünge wird eine Kraft, die am zylindrischen Zapfen weitestgehend senkrecht zur Berührstelle mit dem Untergrundelement wirkt, in etwa gleichmäßig in den flächigen Halter verteilt. Weiterhin vereinfacht die kegelstumpfartige Ausgestaltung die Herstellung, beispielsweise in einem Spritzgussverfahren.

In einer weiteren Ausgestaltung der Erfindung ist wenigstens einer der weitestgehend zylindrischen Zapfen der kegelstumpfartigen Becherform zur Fixierung des Halters verlängert ausgebildet. Dazu ist dieser verlängerte Zapfen in eine Öffnung in einem flächigen Teil des Unterbaus einbringbar. Dadurch kann der Halter in seiner Relativposition zum Unterbau fixiert werden. Der Halter kann dabei eine beliebige Anzahl verlängerter Zapfen aufweisen, vorzugsweise sind es zwischen 2 und 4. Zur Fixierung des Halters können auch Bohrungen im Halter oder Laschen an den Außenseiten des Halters vorgesehen werden, in die Nasen oder Zapfen des Unterbaus hineinragen.

In einer Ausgestaltung der Erfindung sind die Vorsprünge rohrartig ausgebildet. Sie können an wenigstens zwei, vorzugsweise vier, der umlaufenden Kanten des Halters in den flächigen Halter übergehen.

In einer weiteren Ausgestaltung der Erfindung weist der Halter einen plattenartig ausgebildeten Hauptkörper und einen dem Hauptkörper zumindest teilweise umgebenden, relativ zur Grundfläche des Hauptkörpers in wenigstens eine Ausdehnungsrichtung abstehenden Rand auf. Die Ausdehnungsrichtung ist vorzugsweise senkrecht zur Grundfläche des Hauptkörpers orientiert, so dass durch den Rand und die Grundfläche eine wannenartige Form zum Einlegen eines zu fixierenden Bauteilträgers gebildet ist. Die wannenartige Form ist derart dimensioniert, dass der dazu fixierende Bauteilträger wenigstens teilweise durch Klemmen darin festgehalten wird. Durch die weitestgehend senkrechte Orientierung des Randes zur Grundfläche des Hauptkörpers wird die Ausdehnung des Halters nur geringfügig vergrößert. Es ist denkbar, dass der Rand in beide Ausdehnungsrichtungen senkrecht relativ zur Grundfläche des Hauptkörpers absteht. So kann der Rand an der einen Seite als Aufnahme für einen Bauteilträger verwendet werden. Der Rand der gegenüberliegenden Seite kann dazu verwendet werden, den Anpressdruck des Bauteilträgers an eine Abdeckung zu vergrößern, indem der, Rand, den zylindrischen Zapfen gleich, an einem flächigen Untergrundelement des Unterbaus angelegt wird.

In einer weiteren Ausbildung der Erfindung kann auf die Ränder teilweise oder ganz verzichtet werden. Dabei kann der Bauteilträger anderweitig, beispielsweise durch Kleben, an den Hauptkörper fixiert werden. Eine Höhenbegrenzung des Federwegs oder die Erhöhung der Anpresskraft durch den Rand wird dann nicht mehr benötigt.

In einer weiteren Ausgestaltung der Erfindung sind die Vorsprünge in eine Richtung orientiert, die weitestgehend entgegengesetzt der Ausdehnungsrichtung des Randes ist, der den Hauptkörper umgibt. So weist der Halter zwei Seiten auf, denen jeweils eindeutige Funktionen zugewiesen sind. Dadurch ist die Möglichkeit eines fehlerhaften Vorgehens bei der Montage deutlich verringert.

In einer weiteren Ausgestaltung der Erfindung ist an dem Halter wenigstens ein Zapfen mit einer Rastnase vorgesehen. Der Zapfen ragt vorzugsweise in den Bereich, der von dem Rand umgeben ist. Er weist eine zylinderartige Form auf. Mit dem Zapfen kann der Bauteilträger, der in dem Halter zu fixieren ist, gegen Herausfallen aus dem Halter gesichert werden. Dazu sind in dem Bauteilträger Öffnungen vorzusehen, die vorzugsweise entsprechend ausgebildet sind und einen geringfügig vergrößerten Durchmesser im Vergleich zum Durchmesser der Zapfen aufweisen. Die Rastnase an dem Zapfen ist derart ausgebildet, dass die Flanken der Öffnung im Bauteilträger in einer Richtung, die parallel zur Längsachse des zylinderartigen Zapfens ist, über die Rastnase geführt werden kann. In die entgegengesetzte Richtung wird die Bewegung des Bauteilträgers durch die Rastnase blockiert. An dem Zapfen kann eine Ausnehmung, beispielsweise für eine Schraube, vorgesehen sein. Die Ausnehmung ist vorteilhaft von der Seite in den Zapfen eingebracht, mit der dieser am Halter anliegt. Vorteilhaft weisen die Flanken der Ausnehmung Gewindegänge auf. Diese reichen deutlich bis über die Rastnase. Ist ein Bauteilträger über die Rastnasen geführt, kann mit einer Schraube der Zapfen versteift und die Rastnase in Richtung des Grundkörpers des Bauteilträgers herangezogen werden, um so ein Anpressen des Bauteilträgers an den Grundkörper zu erzielen.

In einer weiterführenden Ausgestaltung der Erfindung ist der Halter aus einem elastischen Material gefertigt, das vorzugsweise temperaturresistent ist, insbesondere temperaturresistent bis 200°C oder 400 °C. Das elastische Material macht es möglich, dass der ganze Halter selbst als Federelement verwendet werden kann. Die Temperaturresistenz ist wegen der Verwendung des Halters beispielsweise in einem Glaskeramikkochfeld nötig. Dabei ist zu beachten dass das Material, aus dem der Halter gefertigt ist, in dem angestrebten Temperaturbereich etwa weitestgehend gleichbleibende Materialeigenschaften aufweist.

In einer weiteren Ausgestaltung der Erfindung ist der Halter aus einem Silikonelastomer gefertigt. Dieses Material weist den Vorteil auf, das es in einem Spritzgussverfahren angewendet werden kann und Materialeigenschaften aufweist, die im Verwendungsbereich genügen.

In einer weiteren Ausgestaltung der Erfindung weist der Halter eine Höhe bis zu 50mm auf, vorzugsweise beträgt diese Höhe zwischen 6mm und 18mm. Die geringe Höhe ermöglicht es, dass eine gesamte Anordnung flach gehalten werden kann.

Diese und weitere Merkmale gehen außer aus den Ansprüchen auch aus der Beschreibung und den Zeichnungen hervor, wobei die einzelnen Merkmale jeweils für sich alleine oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischenüberschriften beschränken die unter diesen gemachten Aussagen nicht in ihrer Allgemeingültigkeit.

### Kurzbeschreibung der Zeichnungen

Eine beispielhafte Ausführungsform ist in den Zeichnungen schematisch dargestellt und wird im Folgenden näher erläutert. In den Zeichnungen zeigen:
- Fig. 1: eine isometrische Ansicht der Unterseite einer erfindungsgemäßen Flächenfeder,
- Fig. 2: eine Draufsicht auf die Flächenfeder gemäß Fig.1,
- Fig. 3: eine Unteransicht der erfindungsgemäßen Flächenfeder gemäß Fig. 1,
- Fig. 4: eine Schnittansicht der Flächenfeder gemäß der Linie A-A in Fig. 2, und
- Fig. 5: eine Schnittansicht der Flächenfeder gemäß der Linie B-B in Fig. 2.

### Detaillierte Beschreibung der Zeichnungen

Fig.1 zeigt einen erfindungsgemäßen Halter 10, an dessen Unterseite 12 Vorsprünge 14 angeordnet sind. Die Vorsprünge 14 bilden drei weitestgehend parallele Reihen 16, 18, 20. In die rechteckige Grundform des Halters 10 sind zwei Ausnehmungen 22 eingebracht. Durch diese Ausnehmungen 22 werden, wenn in dem Halter ein nicht dargestellter Bauteilträger angeordnet ist, ebenfalls nicht dargestellte Anschlussleitungen hindurchgeführt, beispielsweise zur elektrischen Verbindung der Bauteile auf dem Bauteilträger.

Die Vorsprünge 14 sind an ihrer Basis an der Unterseite 12 in etwa so breit wie sie hoch sind. Mit den zur Unterseite 12 parallelen Stirnseiten 24 der Vorsprünge 14 liegt der Halter 10 im vollständig montierten Zustand an einem nicht dargestellten Untergrund an, beispielsweise der Bodenplatte eine Elektrogeräts.

Fig.2 zeigt eine Draufsicht auf den Halter 10 mit den parallelen Vorsprungsreihen 16, 18, 20. In den Seitenbereichen des Halters 10 sind Wandungen 26, 28, 30, 32 vorgesehen. Die Länge der Wandungen entlang der Seiten ist kürzer als die Seiten, an denen die Wandungen angebracht sind. Daraus ergibt sich, dass die Ecken 34, 36, 38, 40 keine Wandungen aufweisen. Dies ist vorgesehen, damit die Ecken eines in den Halter 10 einzubringenden Bauteilträger beim Einbringen nicht beschädigt werden und die Zapfen 54 auch per Hand leicht erreichbar sind. Darüber hinaus wird das Einbringen des Bauteilträgers in den Halter 10 dadurch erheblich erleichtert.

Die einzelnen Vorsprünge 14 sind mit Rinnen 42 untereinander verbunden. Die Rinnen 42 verhindern, dass sich einer der becherförmigen Vorsprünge 14 an einem in den Halter 10 eingebrachten Bauteilträger festsaugen kann.

Der Fig.3 ist zu entnehmen, dass die Vorsprünge 14 von benachbarten Reihen versetzt zueinander angeordnet sind. Dadurch wird eine möglichst gleichmäßige Verteilung des Anpressdrucks erreicht. Auf die Funktion wird in bezug auf Fig.4 eingegangen. Die in Fig.3 dargestellte Unterseite 12 des Halters 10 weist in den Eckbereichen Sacklochbohrungen 44 auf, die in Fig.5 deutlicher dargestellt sind.

Fig.4 zeigt eine Schnittansicht des Halters 10 gemäß der Linie A-A in der Fig.2. Die Vorsprünge 14, die als Hohlkörper ausgebildet sind, weisen eine weitestgehend kegelstumpfartige und becherförmige Gestalt auf. Die Vorsprünge 14 sind einstückig mit dem Halter 10 vorgesehen, bilden jedoch Öffnungen in der Innenseite 46. Sie weisen an den Stirnseiten 24 zylinderförmige Endbereiche auf, die in schräge Flanken 50 übergehen, die ihrerseits in den Boden 52 des Halters 10 übergehen. Der Winkel a, der vom Boden 52 und den Flanken 50 gebildet wird, kann in einem Bereich zwischen 0° und 180° liegen, vorzugsweise zwischen 90° und 160°. Bei der bevorzugten Ausführungsform beträgt er 135°.

In dem von den Wandungen 26, 28, 30, 32 gebildeten Innenraum sind Zapfen 54 vorgesehen. Sie sind, wie der Fig.5 zu entnehmen ist, deckungsgleich mit den Bohrungen 44 ausgerichtet. Sie dienen der Befestigung eines in den Halter 10 eingebrachten Bauteilträgers.

In einem montierten Zustand des Halters 10 ist in dessen Innenbereich ein Bauteilträger eingebracht. Weiterhin liegen die Oberkanten 56 der Wandungen 26, 28, 30, 32 an einer strichpunktierten Abdeckung 70 an, vorzugsweise einem Glaskeramikkochfeld. Gleichzeitig liegen die Stirnseiten 24 der Vorsprünge 14 an einem gestrichelt dargestellten Unterbau 72 an. Der Abstand zwischen dem Unterbau und dem Glaskeramikkochfeld ist dabei geringer als die Höhe h₁ und größer als die Höhe h₂. Dadurch werden die Flanken 50 der Vorsprünge 14 verformt, nämlich nach außen gedrückt. Die verformten Flanken 58 sind gestrichelt angedeutet. Diese Verformung bewirkt durch die federelastischen Eigenschaften des verwendeten Materials einen Anpressdruck zumindest an den Oberseiten 56 der Wandungen 26, 28, 30, 32. Weist der nicht dargestellte Bauteilträger die maximale Höhe h₃, und die auf dem Bauteilträger angebrachten Bauteile mindestens die Höhe h₄ auf, so wirkt der durch die Verformungen der Vorsprünge 14 erzeugte Anpressdruck ebenfalls auf die Oberseiten der Bauteile. Dies ist besonders relevant, wenn die Bauteile Teil eines Berührschalters sind, die plan an der Unterseite der Abdeckung anliegen sollten.

Um ein Verrutschen des Halters 10 im montierten Zustand zu verhindern weisen, wie auch in Fig.1 dargestellt, wenigstens zwei Vorsprünge 60 eine Verlängerung 62 des zylindrischen Abschnitts auf. Dieser kann in entsprechende Ausnehmungen im Unterbau eingebracht werden.

Wie der Fig.5 zu entnehmen ist, weist der Zapfen 54 wenigstens einen oberen zylindrischen Abschnitt 64 mit einem ersten Durchmesser, einen kegelstumpfartigen Abschnitt 66 und einen zweiten zylindrischen Abschnitt eines zweiten Durchmessers auf. Der zweite Durchmesser ist merklich größer als der erste, jedoch kleiner als die größte Ausdehnung des Kegelstumpfs 66. Die kleinste Ausdehnung des Kegelstumpfs 66 geht übergangslos in den Zylinder 64 über. Der Kegelstumpf 66 bildet eine Rastnase. Der Zapfen ist einstückig und somit aus dem gleichen, federelastischen Material wie der Halter 10 ausgebildet. Der Übergang zwischen Zapfen 54 und Boden 52 liegt im Bereich des Zylinders mit dem zweiten Durchmesser. Konzentrisch zu den Zylindern ist eine Ausnehmung 44 durch den Boden, den Zylinder mit dem zweiten Durchmesser und Teilen des Kegelstumpfs eingebracht.

Der Zapfen 54 dient zur Sicherung eines punktiert dargestellten eingebrachten Bauteilträgers 74 gegen Herausfallen. Dazu werden Öffnungen, die im Bauteilträger 74 vorgesehen sind, über den Zapfen 54 geführt, bis der Bauteilträger in einer Position im Bereich des Zylinders 68 liegt. Die durch den Kegelstumpf 66 gebildete Rastnase bildet eine primäre Fixierung des Bauteilträgers. Durch die federelastischen Eigenschaften des Materials, aus dem der Halter 10 gefertigt ist, und der Bohrung 44, die in den Zapfen eingebracht ist, ist diese Rastverbindung reversibel. In diese Bohrung 44 kann ein Montagestift eingeführt werden, der den Zapfen elastisch verjüngt, wenn die Fläche 46 durch einen Bauteilträger 74 niedergehalten wird. Dabei lässt sich dann der Zapfen 44 leicht in den in die Öffnung des Bauteilträgers 74 einführen. Beim Zurückziehen des Montagestiftes verastet der Zapfen 54 in den Bauteilträger 74. Mit einer nicht dargestellten Schraube oder einem Bolzen, die vorzugsweise einen Senkkopf aufweisen und in die Bohrung 44 eingebracht werden, lässt sich die Fixierung des Bauteilträgers bei Bedarf zusätzlich sichern.

Die Erfindung kann somit beispielsweise einen Halter für die Fixierung wenigstens eines flächigen Bauteilträgers 74 schaffen, insbesondere für die Fixierung von Leiterplatten für eine Berührschalter-Einheit eines Glaskeramikkochfeldes, zwischen einer Abdeckung 70 und einem den Bauteilträger 74 aufnehmenden Unterbau 72. Dabei weist der Halter 10 eine Anzahl von elastische Vorsprüngen 14 auf, die an einer Seite des Halters 10 einstückig und flächig verteilt sind und eine Flächenfeder bilden. Der Halter 10 kann den Bauteilträger 74 dabei auch umgreifen bzw. umrahmen und somit aufnehmen.

## Patentansprüche

1. Halter (10) für die Fixierung von wenigstens einem flächigen Bauteilträger (74) zwischen einer Abdeckung (70) und einem den Bauteilträger (74) aufnehmenden Unterbau (72), insbesondere für die Fixierung von Leiterplatten für eine Berührschalter-Einheit eines Glaskeramikkochfeldes, wobei der Halter (10) eine Anzahl von elastischen Vorsprüngen (14) aufweist, die an einer Seite (12) des Halters (10) einstückig und flächig verteilt sind und eine Flächenfeder bilden, **dadurch gekennzeichnet, dass** die Vorsprünge (14) Hohlkörper sind.

2. Halter nach Anspruch 1, **dadurch gekennzeichnet, dass** die Vorsprünge (14) einen geringen Abstand zueinander aufweisen, wobei der Abstand vorzugsweise in etwa der Breite eines Vorsprungs (14) entspricht.

3. Halter nach einem der Ansprüche 1 oder 2, **dadurch gekennzeichnet, dass** die Vorsprünge (14) eine Becherform aufweisen, die insbesondere kegelstumpfartig ist, wobei diese vorzugsweise einen weitestgehend zylindrischen Zapfen an deren kleineren Durchmesserseite aufweisen, mit deren freier Stirnseite (24) die Körper an einem flächigen Unterbau (72) anlegbar sind, und wobei die Körper vorzugsweise mit der größeren Durchmesserseite in den flächigen Halter (10) übergehen.

4. Halter nach Anspruch 3, **dadurch gekennzeichnet, dass** wenigstens einer der weitestgehend zylindrischen Zapfen (62) der Vorsprünge (60) zur Fixierung des Halters (10) verlängert ausgebildet ist zum Einbringen des verlängerten Zapfens (62) in eine Öffnung in einem flächigen Teil des Unterbaus (72).

5. Halter nach einem der vorhergehenden Ansprüche, **dadurch gekennzeichnet, dass** die Vorsprünge rohrartig ausgebildet sind, wobei die Vorsprünge an wenigstens zwei, vorzugsweise vier, der umlaufenden Kanten des Halters (10) in den flächigen Halter übergehen.

6. Halter nach einem der vorhergehenden Ansprüche, **dadurch gekennzeichnet, dass** der Halter (10) einen plattenartig ausgebildeten Hauptkörper und einen, den Hauptkörper zumindest teilweise umgebenden, relativ zur Grundfläche des Hauptkörpers in wenigstens eine Ausdehnungsrichtung abstehenden Rand (26, 28, 30, 32) aufweist, wobei vorzugsweise die Ausdehnungsrichtung weitestgehend senkrecht zur Grundfläche des Hauptkörpers orientiert ist, so dass durch den Rand (26, 28, 30, 32) und die Grundfläche eine wannenartige Form zum Einlegen eines zu fixierenden Bauteilträgers (74) gebildet ist.

7. Halter nach Anspruch 6, **dadurch gekennzeichnet, dass** die Vorsprünge (14) in eine Richtung orientiert sind, die weitestgehend entgegengesetzt der Ausdehnungsrichtung des Randes (26, 28, 30, 32) ist, der den Hauptkörper umgibt.

8. Halter nach einem der Ansprüche 1 bis 5, **dadurch gekennzeichnet, dass** der Halter (10) einen plattenartig ausgebildeten Hauptkörper aufweist, der randlos ausgebildet ist.

9. Halter nach einem der vorstehenden Ansprüche, **dadurch gekennzeichnet, dass** an dem Halter (10) wenigstens ein Zapfen (54) mit einer Rastnase (66) vorgesehen ist.

10. Halter nach einem der vorstehenden Ansprüche, **dadurch gekennzeichnet, dass** der Halter (10) aus einem elastischen Material gefertigt ist, das vorzugsweise temperaturresistent, insbesondere temperaturresistent bis 400°C ist, wobei es vorzugsweise ein Silikonelastomer ist.

11. Halter nach einem der vorstehenden Ansprüche, **dadurch gekennzeichnet, dass** der Halter (10) eine Höhe bis zu 50mm aufweist, die vorzugsweise zwischen 6mm und 18mm beträgt.

## Claims

1. Support (10) for fixing at least one flat component carrier (74) between a cover (70) and a substructure (72) receiving the component carrier (74), in particular for fixing printed circuit boards for a contact switch unit of a glass ceramic hob, the support (10) having a number of elastic projections (14) spread in one piece and in arial manner over one side (12) of the support (10) and forming a flat spring, **characterized in that** the projections (14) are hollow elements.

2. Support according to Claim 1, **characterized in that** the projections (14) are a short distance apart, the distance preferably corresponding to approximately the width of a projection (14).

3. Support according to Claim 1 or 2, **characterized in that** the projections (14) have a cup form which is in particular frustum-shaped, where they preferably have a largely cylindrical pin on the side with the smaller diameter, the elements can be brought into contact with a flat substructure (72) by their free end faces (24), and where the elements preferably merge at their side with the larger diameter into the flat support (10).

4. Support according to Claim 3, **characterized in that** at least one of the largely cylindrical pins (62) of the projections (60) for fixing the support (10) is designed extended for insertion of the extended pin (62) into an opening in a flat part of the substructure (72).

5. Support according to one of the preceding claims, **characterized in that** the projections are designed tubular, where the projections merge into the flat support at at least two, preferably four, of the all-round rims of the support (10).

6. Support according to one of the preceding claims, **characterized in that** the support (10) has a main element of plate-like design and a rim (26, 28, 30, 32) at least partially surrounding the main element and projecting in at least one extension direction relative to the basic surface of the main element, the extension direction preferably being oriented largely vertical to the basic surface of the main element such that a trough-like form is formed by the rim (26, 28, 30, 32) and by the basic surface for insertion of a component carrier (74) to be fixed.

7. Support according to Claim 6, **characterized in that** the projections (14) are oriented in a direction largely opposite to the extension direction of the rim (26, 28, 30, 32) surrounding the main element.

8. Support according to one of Claims 1 to 5, **characterized in that** the support (10) has a main element of plate-like design provided without a rim.

9. Support according to one of the preceding claims, **characterized in that** at least one pin (54) with an engaging lug (66) is provided on the support (10).

10. Support according to one of the preceding claims, **characterized in that** the support (10) is made from an elastic material which is preferably temperature-resistant, in particular temperature-resistant up to 400°C, where it is preferably a silicone elastomer.

11. Support according to one of the preceding claims, **characterized in that** the support (10) has a height up to 50 mm, and preferably between 6 mm and 18 mm.

## Revendications

1. Plaquette (10) destinée à la fixation d'au moins un support de composants mince (74) entre un élément de recouvrement (70) et un substrat (72) logeant le support de composants (74), en particulier à la fixation de cartes de circuits imprimés pour une unité de commutateurs tactiles d'une plaque de cuisson en céramique, sachant que la plaquette (10) présente un certain nombre de parties saillantes élastiques (14) qui sont réparties en nappe en formant une seule pièce sur une face (12) de la plaquette (10) et constituent un ressort de grande étendue, **caractérisée en ce que** les parties saillantes (14) sont des corps creux.

2. Plaquette selon la revendication 1, **caractérisée en ce que** les parties saillantes (14) présentent une faible distance entre elles, sachant que de préférence la distance correspond approximativement à la largeur d'une partie saillante (14).

3. Plaquette selon l'une des revendications 1 ou 2, **caractérisée en ce que** les parties saillantes (14) ont une forme de godet, qui est en particulier tronconique, et que de préférence, elles présentent du côté de leur petit diamètre un téton essentiellement cylindrique, avec la face frontale libre (24) duquel les corps peuvent s'appuyer sur un substrat mince (72), et que de préférence les corps se fondent avec la plaquette mince (10) du côté de leur grand diamètre.

4. Plaquette selon la revendication 3, **caractérisée en ce qu'**au moins un des tétons essentiellement cylindriques (62) des parties saillantes (60) destinées à fixer la plaquette (10) est prolongé pour introduire le téton prolongé (62) dans une ouverture pratiquée dans une partie mince du substrat (72).

5. Plaquette selon l'une des revendications précédentes, **caractérisée en ce que** les parties saillantes ont une forme tubulaire, sachant que les parties saillantes se fondent dans la plaquette mince sur au moins deux, de préférence quatre arêtes périphériques de la plaquettes (10).

6. Plaquette selon l'une des revendications précédentes, **caractérisée en ce que** la plaquette (10) présente un corps pelliculaire en forme de plaque et un bord (26, 28, 30, 32) entourant au moins partiellement le corps pelliculaire et faisant saillie par rapport à la surface de base du corps pelliculaire dans au moins une direction d'extension, sachant que de préférence la direction d'extension est essentiellement orientée perpendiculairement à la surface de base du corps pelliculaire, de manière telle que par le bord (26, 28, 30, 32) et la surface de base est constituée une forme en cuvette pour insérer un support de composants (74) à fixer.

7. Plaquette selon la revendication 6, **caractérisée en ce que** les parties saillantes (14) sont orientées dans une direction qui est essentiellement opposée à la direction d'extension du bord (26, 28, 30, 32) qui entoure le corps pelliculaire.

8. Plaquette selon l'une des revendications 1 à 5, **caractérisée en ce que** la plaquette (10) présente un corps pelliculaire en forme de plaque formé sans bord.

9. Plaquette selon l'une des revendications précédentes, **caractérisée en ce que** sur la plaquette (10) est prévu au moins un téton (54) avec un taquet d'arrêt (66).

10. Plaquette selon l'une des revendications précédentes, **caractérisée en ce que** la plaquette (10) est fabriquée avec un matériau élastique qui de préférence résiste à la chaleur, en particulier à des températures jusqu'à 400 °C, sachant qu'il est de préférence un élastomère à la silicone.

11. Plaquette selon l'une des revendications précédentes, **caractérisée en ce que** la plaquette (10) présente une hauteur pouvant atteindre 50 mm, qui est de préférence comprise entre 6 mm et 18 mm.
